# EUROPEAN PATENT APPLICATION

(11) **EP 2 600 579 A1**
(43) Date of publication of application: **05.06.2013**
(21) Application number: 11811734.0
(22) Date of filing: 16.02.2011
(51) Int. Cl.: H04L 27/26

(54) **METHOD AND APPARATUS FOR ESTIMATING FINE FREQUENCY OFFSET**

(30) Priority: 30.07.2010 CN 201010242979
(71) Applicant: ZTE Corporation, Shenzhen, Guangdong 518057 (CN)
(72) Inventor: QIU, Ning, Guangdong 518057 (CN); LI, Qiang, Guangdong 518057 (CN); ZENG, Wenqi, Guangdong 518057 (CN); YU, Tiankun, Guangdong 518057 (CN); LIU, Zhongwei, Guangdong 518057 (CN); XING, Yannan, Guangdong 518057 (CN); LIANG, Lihong, Guangdong 518057 (CN); LI, Liwen, Guangdong 518057 (CN); LIN, Feng, Guangdong 518057 (CN); CHU, Jintao, Guangdong 518057 (CN); CHEN, Xinhua, Guangdong 518057 (CN)
(74) Representative: Delorme, Nicolas
(86) International application number: PCT/CN2011/071032
(87) International publication number: WO 2012/013032

(57) **Abstract**

The present invention discloses a fine frequency offset estimation method and apparatus. The method comprises: calculating a first accumulated estimation value corresponding to a first multiframe state according to a phase relevant value of a subframe and a phase of a subframe in the first multiframe state; calculating a second accumulated estimation value corresponding to a second multiframe state according to the phase relevant value of the subframe and a phase of a subframe in the second multiframe state; determining that a decision result of a multiframe state is the first multiframe state or the second multiframe state according to the first accumulated estimation value and the second accumulated estimation value; and performing a fine frequency offset estimation according to the decision result of the multiframe state. The apparatus disclosed in the present invention is less coupled with other modules, has excellent performance in various environments, and realizes the unbiased estimation of timing offset.

## Description

### Field of the Invention

The present invention relates to the field of communication, in particular to a fine frequency offset estimation method and apparatus.

### Background of the Invention

At present, in a Time Division-Synchronous Code Division Multiple Access (TD-SCDMA) system, a base station and a terminal both perform sending and receiving in a nominal carrier frequency.

In the TD-SCDMA system, it is required that a carrier frequency error of the base station should be less than 0.05PPM and the carrier frequency error of a user terminal should be less than 0.1PPM. In the base station, with a small restriction on temperature, volume, power consumption, cost and the like, a frequency precision of an oscillator can meet the requirement, while, in the user terminal, generally, due to various restrictions, the frequency precision of a selected crystal oscillator cannot meet the standard requirement. The role of an Automatic Frequency Control (AFC) is to correct the carrier frequency error between the base station and the terminal so as to ensure a working performance of subsequent demodulation and decoding.

In the related arts, a frequency offset estimation method can be classified into coarse frequency offset estimation and fine frequency offset estimation.

The coarse frequency offset estimation is to divide Downlink Synchronous code (SYNC-DL, carried in Downlink Pilot Time Slot (DwPTS)) or Midamble data into two parts, respectively perform channel estimation on the two parts in turn and calculate a carrier frequency offset by the difference of phase rotation of estimation values of the two parts. Central locations of the two parts of data are at an interval of 32 chips or 64 chips, and the estimation range is +/-20kHz or +/-10kHz, wherein the DwPTS and Midamble data are in a known sending format given by the TD-SCDMA standard and used for assisting the terminal to realize timing synchronization, frequency synchronization, scrambling code identification and other functions.

The coarse frequency offset estimation has the advantage of large estimation range but is poor in resolution precision, therefore, in an actual application, the coarse frequency offset estimation is often used in combination with the fine frequency offset estimation to implement the high-quality demodulation of a data service, particularly a high data rate service, such as High Speed Downlink Packet Access (HSDPA).

In the related arts, the fine frequency offset estimation method is to, in a case that there is a small amount of residual frequency offset in a system, jointly detect the linear change of an output constellation phase over time and perform a hard decision by one or more symbols before and after the Midamble of a service time slot to determine a frequency offset estimation value by comparing a phase rotation at a specific data interval. However, the fine frequency offset estimation based on the hard decision of the data segment of the service time slot has the following problems.
(1) Low data signal-to-noise ratio: in order to improve the system capacity, a downlink power control based on a "just enough" principle is introduced for the service time slot, and in most scenarios of a cell, the signal-to-noise ratio of the service time slot can meet the lowest requirement of the service Block Error Ratio (BLER).
(2) Hard decision error: Turbo coding with 1/3 code rate can run normally only if the symbol error rate is slightly lower than 20%, therefore, when the downlink power control is enabled, many hard decision errors are inevitable in a normal working area, thereby limiting the frequency offset estimation performance to a certain extent.
(3) Tightly coupled modules: the quality of the data subjected to the joint detection depends on the working conditions of multiple modules, such as precise timing module, channel estimation module, frequency offset compensation module and joint detection module, and most of these modules require a small residual frequency offset for reliable work, as a result, the modules are related with one another, which is unfavorable to improve the reliability of the system.

### Summary of the Invention

The present invention is provided to solve the problems that the fine frequency offset estimation performed based on the hard decision of the data segment of the service time slot is low in data signal-to-noise ratio, influenced by hard decision errors and obviously coupled with other modules, therefore, the present invention provides a fine frequency offset estimation method and apparatus, so as to solve the problems.

According to one aspect of the present invention, the present invention provides a fine frequency offset estimation method.

The fine frequency offset estimation method comprises: calculating a first accumulated estimation value corresponding to a first multiframe state according to a phase relevant value of a subframe and a phase of a subframe in the first multiframe state; calculating a second accumulated estimation value corresponding to a second multiframe state according to the phase relevant value of the subframe and a phase of a subframe in the second multiframe state; determining that a decision result of a multiframe state is the first multiframe state or the second multiframe state according to the first accumulated estimation value and the second accumulated estimation value; and performing a fine frequency offset estimation according to the decision result of the multiframe state.

Preferably, the step of calculating the first accumulated estimation value corresponding to the first multiframe state according to the phase relevant value of the subframe and the phase of the subframe in the first multiframe state comprises: calculating CorrR1=CorrR1+CorrC×conj(S1(MFPhs)) to obtain the first accumulated estimation value, wherein CorrR1 is the first accumulated estimation value, CorrC is the phase relevant value of the subframe, S1(MFPhs) is the phase of the subframe in the first multiframe state, and conj is used for calculating a conjugate complex of S1(MFPhs).

Preferably, before the step of calculating the first accumulated estimation value corresponding to the first multiframe state according to the phase relevant value of the subframe and the phase of the subframe in the first multiframe state, the method further comprises: numbering the subframe in the first multiframe state by MFPhs according to a time order of the subframe in the first multiframe state; and calculating CorrR1=zeros(2, 1) to obtain the first accumulated estimation value that is cleared, wherein CorrR1 is the first accumulated estimation value, and zeros is used for clearing CorrR1.

Preferably, the step of calculating the second accumulated estimation value corresponding to the second multiframe state according to the phase relevant value of the subframe and the phase of the subframe in the second multiframe state comprises: calculating CorrR2=CorrR2+CorrC×conj(S2(MFPhs)) to obtain the second accumulated estimation value, wherein CorrC is the phase relevant value of the subframe, and S2(MFPhs) is the phase of the subframe in the second multiframe state.

Preferably, before the step of calculating the second accumulated estimation value corresponding to the second multiframe state according to the phase relevant value of the subframe and the phase of the subframe in the second multiframe state, the method further comprises: numbering the subframe in the second multiframe state by MFPhs according to a time order of the subframe in the second multiframe state; and calculating CorrR2=zeros(2, 1) to obtain the second accumulated estimation value that is cleared, wherein CorrR2 is the second accumulated estimation value, and zeros is used for clearing CorrR2.

Preferably, the step of determining that the decision result of the multiframe state is the first multiframe state or the second multiframe state according to the first accumulated estimation value and the second accumulated estimation value comprises: calculating [CorrM, S12Est]=max(abs(CorrR1), abs(CorrR2)) to obtain the decision result of the multiframe state, wherein CorrM is a larger value of an absolute value of CorrR1 and an absolute value of CorrR2, S12Est is the decision result of the multiframe state, CorrR1 is the first accumulated estimation value, CorrR2 is the second accumulated estimation value, abs is used for performing a modulo operation on CorrR1 and CorrR2, and max is used for calculating a larger value of abs(CorrR1) and abs(CorrR2).

Preferably, the step of performing the fine frequency offset estimation according to the decision result of the multiframe state comprises: calculating FeqEst=angle(CorrR(S12Est))/pi×(1.28e6/496/2) to obtain a fine frequency offset value, wherein FeqEst is the fine frequency offset value, S12Est is the decision result of the multiframe state, and angle is used for calculating an angle of CorrR(S12Est).

According to another aspect of the present invention, the present invention provides a fine frequency offset estimation apparatus.

The fine frequency offset estimation apparatus according to the present invention comprises: a first calculation module which is configured to calculate a first accumulated estimation value corresponding to a first multiframe state according to a phase relevant value of a subframe and a phase of a subframe in the first multiframe state; a second calculation module which is configured to calculate a second accumulated estimation value corresponding to a second multiframe state according to the phase relevant value of the subframe and a phase of a subframe in the second multiframe state; a determining module which is configured to determine that a decision result of a multiframe state is the first multiframe state or the second multiframe state according to the first accumulated estimation value and the second accumulated estimation value; and a fine frequency offset estimation module which is configured to perform a fine frequency offset estimation according to the decision result of the multiframe state.

Preferably, the first calculation module comprises: a first calculation sub-module which is configured to calculate CorrR1=CorrR1+CorrC×conj(S1(MFPhs)) to obtain the first accumulated estimation value, wherein CorrR1 is the first accumulated estimation value, CorrC is the phase relevant value of the subframe, S1(MFPhs) is the phase of the subframe in the first multiframe state, and conj is used for calculating a conjugate complex of S1(MFPhs).

Preferably, the second calculation module comprises: a second calculation sub-module which is configured to calculate CorrR2=CorrR2+CorrC×conj(S2(MFPhs)) to obtain the second accumulated estimation value, wherein CorrR2 is the second accumulated estimation value, CorrC is the phase relevant value of the subframe, and S2(MFPhs) is the phase of the subframe in the second multiframe state.

Preferably, the determining module comprises: a third calculation sub-module which is configured to calculate [CorrM, S12Est]=max(abs(CorrR1), abs(CorrR2)) to obtain the decision result of the multiframe state, wherein CorrM is a larger value of an absolute value of CorrR1 and an absolute value of CorrR2, S12Est is the decision result of the multiframe state, CorrR1 is the first accumulated estimation value, CorrR2 is the second accumulated estimation value, abs is used for performing a modulo operation on CorrR1 and CorrR2, and max is used for calculating a larger value of abs(CorrR1) and abs(CorrR2).

Preferably, the fine frequency offset estimation module comprises: a fourth calculation sub-module which is configured to calculate FeqEst=angle(CorrR(S12Est))/pi×(1.28e6/496/2) to obtain a fine frequency offset value, wherein FeqEst is the fine frequency offset value, S12Est is the decision result of the multiframe state, angle is used for calculating an angle of CorrR(S12Est), and 1/1.28e6×496 is a duration between a central location of Midamble and a central location of downlink synchronous code.

Through the present invention, the problems that the fine frequency offset estimation performed based on the hard decision of the data segment of the service time slot is low in data signal-to-noise ratio, influenced by hard decision errors and obviously coupled with other modules are solved by determining that the decision result of the multiframe state is the first multiframe state or the second multiframe state and performing the fine frequency offset estimation according to the decision result of the multiframe state. The present invention is less coupled with other modules, has excellent performance in various environments, and realizes the unbiased estimation of timing offset.

### Brief Description of the Drawings

Drawings, provided for further understanding of the present invention and forming a part of the specification, are used to explain the present invention together with embodiments of the present invention rather than to limit the present invention, wherein:
Fig. 1 is a flowchart of a fine frequency offset estimation method according to an embodiment of the present invention;
Fig. 2 is a diagram showing the simulation of a fine frequency offset estimation method according to a preferred embodiment 1 of the present invention;
Fig. 3 is a diagram showing the simulation of a fine frequency offset estimation method according to a preferred embodiment 2 of the present invention;
Fig. 4 is a diagram showing the simulation of a fine frequency offset estimation method according to a preferred embodiment 3 of the present invention;
Fig. 5 is a diagram showing the simulation of a fine frequency offset estimation method according to a preferred embodiment 4 of the present invention;
Fig. 6 is a diagram showing the simulation of a fine frequency offset estimation method according to a preferred embodiment 5 of the present invention;
Fig. 7 is a diagram showing the simulation of a fine frequency offset estimation method according to a preferred embodiment 6 of the present invention; and
Fig. 8 is a block diagram showing the structure of a fine frequency offset estimation apparatus according to an embodiment of the present invention.

### Detailed Description of the Embodiments

It should be noted that, in case of no conflict, the embodiments of the present invention and features therein can be combined with each other. The present invention will be explained below with reference to the drawings and in conjunction with the embodiments in detail.

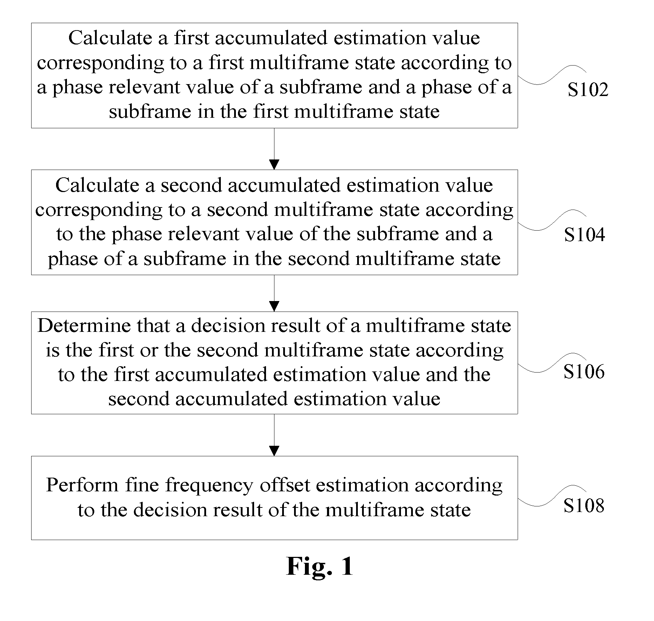

According to an embodiment of the present invention, a fine frequency offset estimation method is provided. Fig. 1 is a flowchart of the fine frequency offset estimation method according to the embodiment, comprising Step S102 to Step S 108 as follows.

Step S102: A first accumulated estimation value corresponding to a first multiframe state is calculated according to a phase relevant value of a subframe and a phase of a subframe in the first multiframe state.

Step S104: A second accumulated estimation value corresponding to a second multiframe state is calculated according to the phase relevant value of the subframe and a phase of a subframe in the second multiframe state.

Step S106: It is determined that a decision result of a multiframe state is the first multiframe state or the second multiframe state according to the first accumulated estimation value and the second accumulated estimation value.

Step S108: Fine frequency offset estimation is performed according to the decision result of the multiframe state.

In the related arts, the fine frequency offset estimation method is to, in a case that there is a small amount of residual frequency offset in a system, jointly detect the linear change of an output constellation phase over time and perform a hard decision by one or more symbols before and after the Midamble of a service time slot to determine a frequency offset estimation value by comparing a phase rotation at a specific data interval.

The basic principle of the embodiment of the present invention is to determine whether the decision result is the first multiframe state or the second multiframe state based on the phase relationships between the Midamble and SYNC-DL of four subframes in the multiframe period, and after such decision of S1/second multiframe state is completed, the fine frequency offset estimation result is output in a period of multiframe by calculating the phase difference between the SYNC-DL and Midamble.

In the embodiment of the present invention, with the more reliable SYNC-DL and Midamble of time slot 0 as data sources, the fine frequency offset estimation is performed in a unit of multiframe based on the phase relationship in the multiframe period, so as not to be influenced by hard decision errors nor obviously coupled with other modules, thereby improving the reliability of the fine frequency offset estimation in the TD-SCDMA system.

Preferably, the process that the first accumulated estimation value corresponding to the first multiframe state is calculated according to the phase relevant value of the subframe and the phase of the subframe in the first multiframe state comprises: CorrR1=CorrR1+CorrC×conj(S1(MFPhs)) is calculated to obtain the first accumulated estimation value, wherein CorrR1 is the first accumulated estimation value, CorrC is the phase relevant value of the subframe, S1(MFPhs) is the phase of the subframe in the first multiframe state, and conj is used for calculating the conjugate complex of S1(MFPhs).

In the preferred embodiment, the accumulated estimation value CorrR1 is calculated each time a subframe is received, wherein CorrC is a phase estimation value obtained by channel estimation, and the method is consistent with the conventional channel estimation technology in process: CorrC=SycDLCT(PathPos)*conj(MidabCT(PathPos)). Not designed for the channel estimation method, here, the embodiment of the present invention only adopts a simple way of obtaining CorrC based on the strongest path determined in a single sampling manner by the SYNC-DL and the channel coefficient in the path.

S1(MFPhs) is the phase of the MFPhs^{th} subframe in the multiframe corresponding to the first multiframe state in Table 1.

**Table 1 Sequence table for SYNC-DL phase modulation**

| Name | 4 continuous phases | Meanings |
|---|---|---|
| S1 | 135, 45, 225, 135 | Primary Common Control Physical Channel (P-CCPCH) existed in the subsequent four subframes |
| S2 | 315, 225, 315, 45 | No P-CCPCH existed in the subsequent four subframes |

Preferably, before the step that the first accumulated estimation value corresponding to the first multiframe state is calculated according to the phase relevant value of the subframe and the phase of the subframe in the first multiframe state, the subframe in the first multiframe state is numbered by MFPhs according to a time order of the subframe in the first multiframe state; and CorrR1=zeros(2, 1) is calculated to obtain the first accumulated estimation value that is cleared, wherein CorrR1 is the first accumulated estimation value, and zeros is used for clearing CorrR1.

In the preferred embodiment, numbering the subframe in the first multiframe state and clearing CorrR1 are preparation steps for the fine frequency offset estimation and can ensure the precision of the fine frequency offset estimation.

Preferably, the process that the second accumulated estimation value corresponding to the second multiframe state is calculated according to the phase relevant value of the subframe and the phase of the subframe in the second multiframe state comprises: CorrR2=CorrR2+CorrC×conj(S2(MFPhs)) is calculated to obtain the second accumulated estimation value, wherein CorrC is the phase relevant value of the subframe, and S2(MFPhs) is the phase of the subframe in the second multiframe state.

In the preferred embodiment, the accumulated estimation value CorrR1 is calculated each time a subframe is received, wherein CorrC is a phase estimation value obtained by channel estimation, and the method is consistent with the conventional channel estimation technology in process: CorrC=SycDLCT(PathPos)*conj(MidabCT(PathPos)). Not designed for the channel estimation method, here, the embodiment of the present invention only adopts a simple way of obtaining CorrC based on the strongest path determined in a single sampling manner by the SYNC-DL and the channel coefficient in the path.

S2(MFPhs) is the phase of the MFPhs^{th} subframe in the multiframe corresponding to the second multiframe state in Table 1.

Preferably, before the step that the second accumulated estimation value corresponding to the second multiframe state is calculated according to the phase relevant value of the subframe and the phase of the subframe in the second multiframe state, the subframe in the second multiframe state is numbered by MFPhs according to a time order of the subframe in the second multiframe state; and CorrR2=zeros(2, 1) is calculated to obtain the second accumulated estimation value that is cleared, wherein CorrR2 is the second accumulated estimation value, and zeros is used for clearing CorrR2.

In the preferred embodiment, numbering the subframe in the first multiframe state and clearing CorrR2 are preparation steps for the fine frequency offset estimation and can ensure the precision of the fine frequency offset estimation.

Preferably, the process that it is determined that the decision result of the multiframe state is the first multiframe state or the second multiframe state according to the first accumulated estimation value and the second accumulated estimation value comprises: [CorrM, S12Est]=max(abs(CorrR1),abs(CorrR2)) is calculated to obtain the decision result of the multiframe state, wherein CorrM is a larger value of an absolute value of CorrR1 and an absolute value of CorrR2, S12Est is the decision result of the multiframe state, CorrR1 is the first accumulated estimation value, CorrR2 is the second accumulated estimation value, abs is used for a modulo operation of CorrR1 and CorrR2, and max is used for calculating the larger value of abs(CorrR1) and abs(CorrR2).

In the preferred embodiment, it is determined that the decision result of the multiframe state is the first multiframe state or the second multiframe state by the accumulated estimation value with a larger modulus.

Furthermore, after the first accumulated estimation value and the second accumulated estimation value are obtained, it is also feasible to determine that the decision result of the multiframe state is the first multiframe state or the second multiframe state by selecting the one with a larger modulus square. The calculation method is max(CorrR1×conj(CorrR1) , CorrR2×conj(CorrR2)), wherein conj is used for calculating a conjugate complex.

It should be noted that the decision result of the multiframe state obtained by calculating the absolute value and that obtained by calculating the modulus square are equivalent in terms of result.

Preferably, the step that the fine frequency offset estimation is performed according to the decision result of the multiframe state comprises: FeqEst=angle(CorrR(S12Est))/pi×(1.28e6/496/2) is calculated to obtain a fine frequency offset value, wherein FeqEst is the fine frequency offset value, S12Est is the decision result of the multiframe state, and angle is used for calculating an angle of CorrR(S12Est).

It should be noted that a chip rate of the TD-SCDMA system is 1.28MHz, so the duration of each chip is 1/1.28e6 seconds. Meanwhile, the central locations of the Midamble and DwPTS are at an interval of 496 chips, so the central locations are at a time interval of 1/1.28e6×496 seconds. That is, 1/1.28e6×496 is the duration between the central locations of the Midamble and DwPTS.

It should be noted that each subframe needs very little storage space and calculation, therefore the evaluation for the storage space and calculation is omitted here.

In order to demodulate Broadcast Channel (BCH) information correctly, the terminal in the TD-SCDMA system must determine an initial location of the multiframe of the BCH in the P-CCPCH at first. Such location is indicated by a Quaternary Phase Shift Keying (QPSK) modulated phase between the Midamble of time slot 0 and the DwPTS.

After the synchronous location of the multiframe is obtained, four subframes in the multiframe will only be in either S1 or S2. After the determination on the first multiframe state and the second multiframe state is implemented by a maximum likelihood estimation method, the frequency offset estimation can be performed by the QPSK modulated phase difference between the Midamble of time slot 0 and the DwPTS. One frequency offset estimation result is output for each multiframe. When the last 128 chips in the 144 Midamble chips of time slot 0 are selected to calculate the phase relationship with the DwPTS, the central locations of the two sequences are at an interval of 496 chips, and the estimable frequency offset range is +/-1290.32Hz.

To understand the embodiments above better, other preferred embodiments of the present invention are further described below.

An analysis for the simulation of the performance of the fine frequency offset estimation method in various scenarios is made in this part.

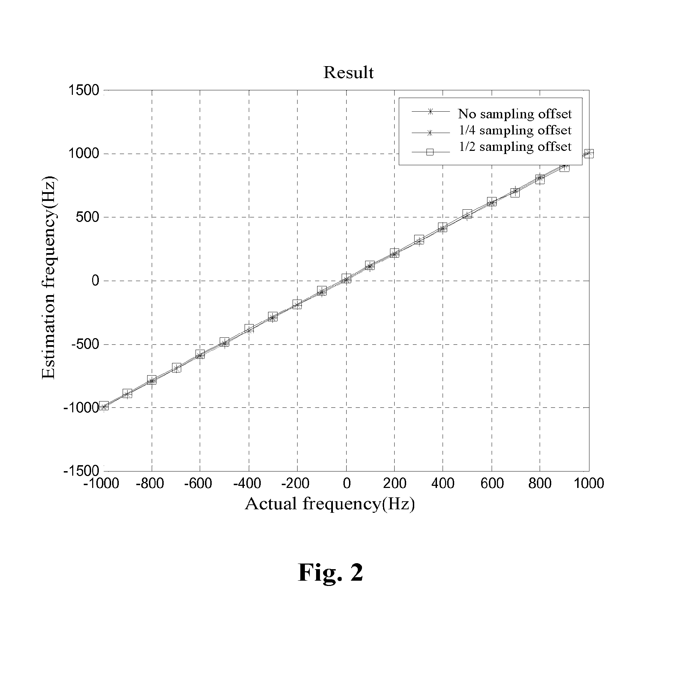

Fig. 2 is a diagram showing the simulation of a fine frequency offset estimation method according to a preferred embodiment 1 of the present invention. As shown in Fig. 2, the influence of estimation linearity and sampling offset on estimation offset in a noiseless environment is analyzed, wherein the x-ordinate shows an actual frequency offset, while the y-ordinate shows a frequency offset estimation value; the red line shows a non-sampling offset, and two blue lines respectively show the conditions when a sampling offset is 1/4chip and 1/2chip. As seen, 1) the estimation is a linear function within the interval; and 2) the frequency offset is the unbiased estimation of the sampled location.

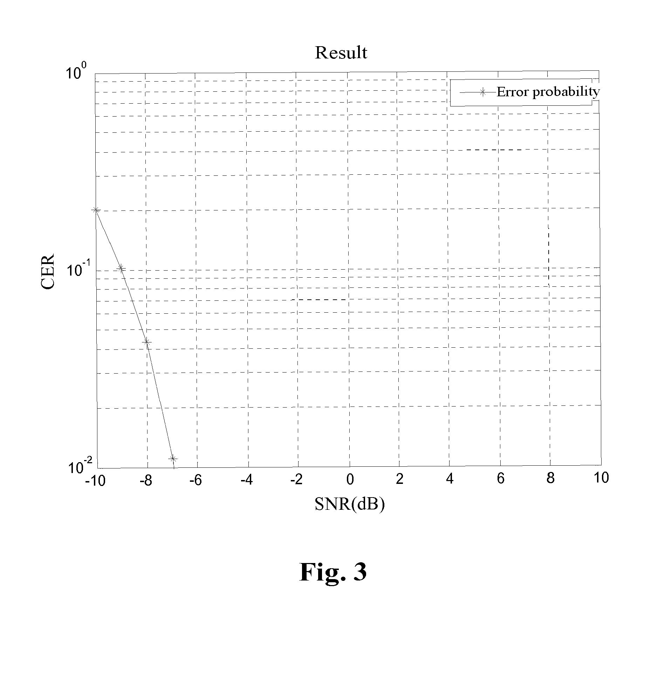

Fig. 3 is a diagram showing the simulation of a fine frequency offset estimation method according to a preferred embodiment 2 of the present invention, and shows the misjudgment probability in S1 and S2 in an Additive Gaussian White Noise (AWGN) channel, wherein 4,000 subframes are simulated at each sampled point, and S1 and S2 are in an equal-probability and random distribution. When the signal-to-noise ratio of Sync-DL is lower than -7dB, certain misjudgment phenomenon will occur; and because the signal-to-noise ratio in an actual working area is far higher than -7dB, the influence of the misjudgment on the frequency offset estimation performance can be ignored.

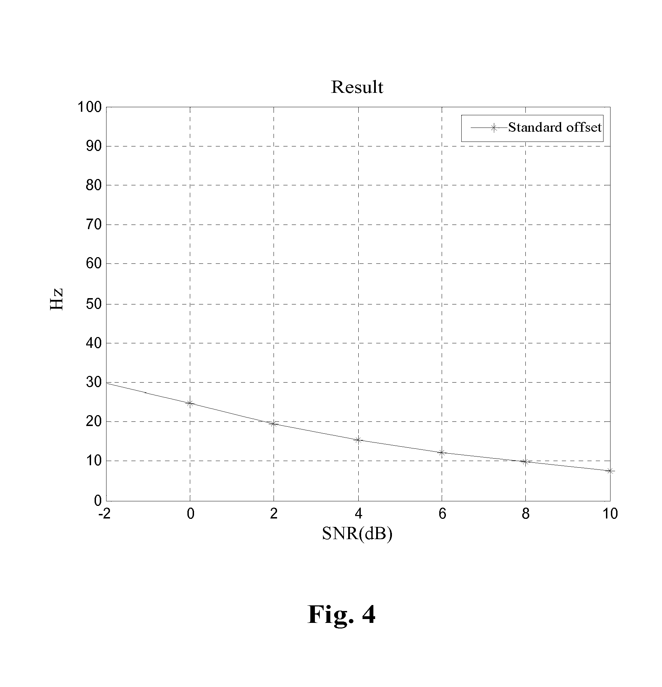

Fig. 4 is a diagram showing the simulation of a fine frequency offset estimation method according to a preferred embodiment 3 of the present invention and shows a standard offset performance of a single estimation result of the frequency offset estimation method in an AWGN channel. The standard offset at a -2dB signal-to-noise ratio is about 30Hz, and the standard offset at a 10dB signal-to-noise ratio is less than 10Hz.

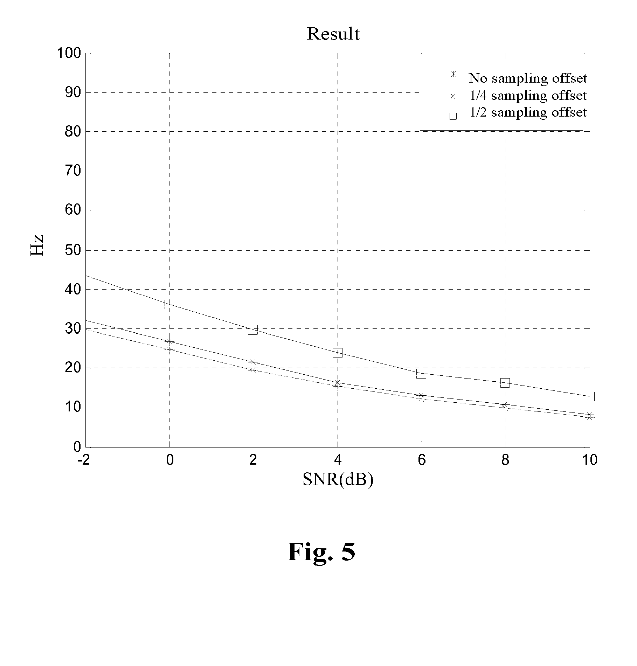

Fig. 5 is a diagram showing the simulation of a fine frequency offset estimation method according to a preferred embodiment 4 of the present invention. As shown in Fig. 5, the channel estimation adopts a single sampling, and the signal-to-noise ratio of the strongest path is reduced due to the path division caused by sampling offset, as a result, the frequency offset estimation performance determined by the strongest path is reduced, and an analysis indicates that the performance is reduced to the same extend as the reduction on the signal-to-noise ratio of the strongest path.

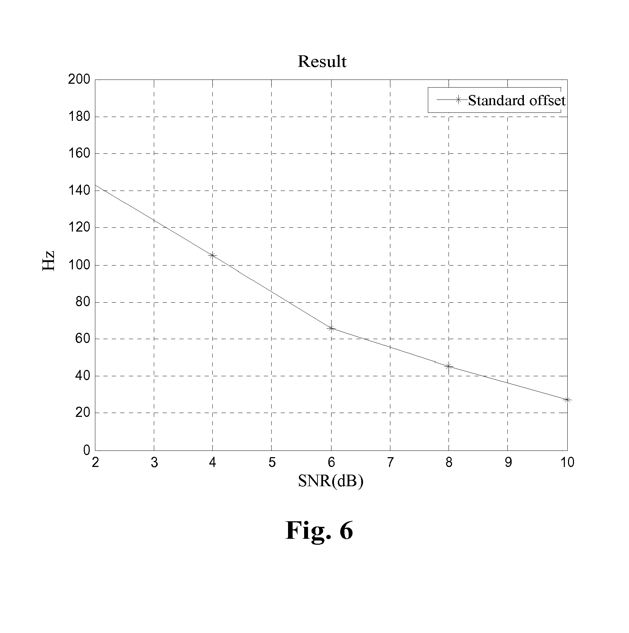

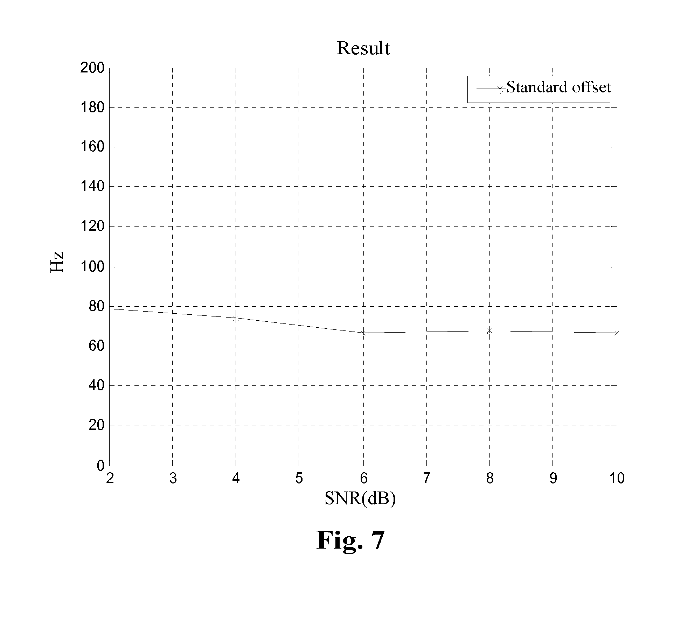

Fig. 6 is a diagram showing the simulation of a fine frequency offset estimation method according to a preferred embodiment 5 of the present invention. Fig. 7 is a diagram showing the simulation of a fine frequency offset estimation method according to a preferred embodiment 6 of the present invention. As shown in Fig. 6 and Fig. 7, the frequency offset estimation performance in a Case 1 and Case 3 channel is simulated respectively. The offset of a single frequency offset estimation at 5dB is lower than 100Hz, and such single estimation result has been very ideal since a deep fading as long as tens of subframes is existed in Case 1, and the maximum Doppler frequency offset in the Case 3 channel has been up to 222Hz. Moreover, the single estimation result will be further filtered in an actual AFC application to achieve a lower magnitude order of the residual frequency offset.

It should be noted that the steps shown in the flowchart of the drawings can be executed, for example, in a computer system with a set of instructions executable by a computer, in addition, a logic order is shown in the flowchart, but the shown or described steps can be executed in a different order under some conditions.

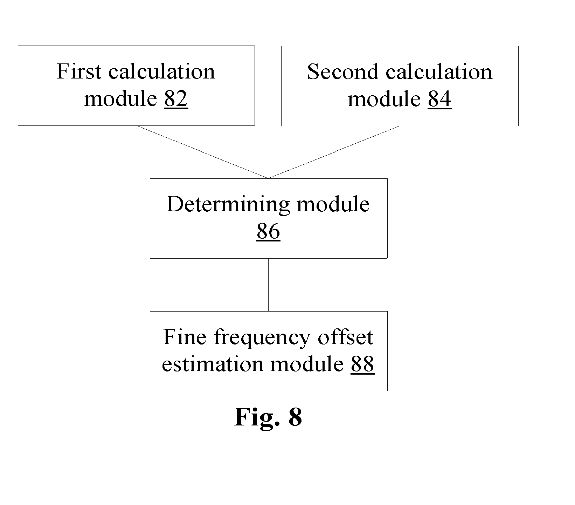

According to an embodiment of the present invention, a fine frequency offset estimation apparatus is provided, which can be configured to implement the fine frequency offset estimation method above. Fig. 8 is a block diagram showing the structure of the fine frequency offset estimation apparatus according to the embodiment, comprising a first calculation module 82, a second calculation module 84, a determining module 86 and a fine frequency offset estimation module 88, which are described below in detail.

The first calculation module 82 is configured to calculate a first accumulated estimation value corresponding to a first multiframe state according to a phase relevant value of a subframe and a phase of a subframe in the first multiframe state; the second calculation module 84 is configured to calculate a second accumulated estimation value corresponding to a second multiframe state according to the phase relevant value of the subframe and a phase of a subframe in the second multiframe state; the determining module 86 is coupled with the first calculation module 82 and the second calculation module 84 and configured to determine that a decision result of a multiframe state is the first multiframe state or the second multiframe state according to the first accumulated estimation value calculated by the first calculation module 82 and the second accumulated estimation value calculated by the second calculation module 84; and the fine frequency offset estimation module 88 is coupled with the determining module 86 and configured to perform a fine frequency offset estimation according to the decision result of the multiframe state determined by the determining module 86.

In the related arts, the fine frequency offset estimation method is to, in a case that there is a small amount of residual frequency offset in a system, jointly detect the linear change of an output constellation phase over time and perform a hard decision by one or more symbols before and after the Midamble of a service time slot to determine a frequency offset estimation value by comparing a phase rotation at a specific data interval.

The basic principle of the embodiment of the present invention is to determine whether the decision result is the first multiframe state or the second multiframe state based on the phase relationships between the Midamble and SYNC-DL of four subframes in the multiframe period, and after such decision of first multiframe state /second multiframe state is completed, the fine frequency offset estimation result is output in a period of multiframe by calculating the phase difference between the SYNC-DL and Midamble.

In the embodiment of the present invention, with the more reliable SYNC-DL and Midamble of time slot 0 as data sources, the fine frequency offset estimation is performed in a unit of multiframe based on the phase relationship in the multiframe period, so as not to be influenced by hard decision errors nor obviously coupled with other modules, thereby improving the reliability of the fine frequency offset estimation in the TD-SCDMA system.

Preferably, the first calculation module 82 comprises: a first calculation sub-module 822 which is configured to calculate CorrR1=CorrR1+CorrC×conj(S1(MFPhs)) to obtain the first accumulated estimation value, wherein CorrR1 is the first accumulated estimation value, CorrC is the phase relevant value of the subframe, S1(MFPhs) is the phase of the subframe in the first multiframe state, and conj is used for calculating the conjugate complex of S1(MFPhs).

In the preferred embodiment, the accumulated estimation value CorrR1 is calculated each time a subframe is received, wherein CorrC is a phase estimation value obtained by channel estimation, and the method is consistent with the conventional channel estimation technology in process: CorrC=SycDLCT(PathPos)*conj(MidabCT(PathPos)). Not designed for the channel estimation method, here, the embodiment of the present invention only adopts a simple way of obtaining CorrC based on the strongest path determined in a single sampling manner by the SYNC-DL and the channel coefficient in the path.

S1(MFPhs) is the phase of the MFPhs^{th} subframe in the multiframe corresponding to the first multiframe state in Table 1.

Furthermore, the second calculation module 84 comprises: a second calculation sub-module 842 which is configured to calculate CorrR2=CorrR2+CorrC×conj(S2(MFPhs)) to obtain the second accumulated estimation value, wherein CorrR2 is the second accumulated estimation value, CorrC is the phase relevant value of the subframe, and S2(MFPhs) is the phase of the subframe in the second multiframe state.

In the preferred embodiment, the accumulated estimation value CorrR1 is calculated each time a subframe is received, wherein CorrC is a phase estimation value obtained by channel estimation, and the method is consistent with the conventional channel estimation technology in process: CorrC=SycDLCT(PathPos)*conj(MidabCT(PathPos)). Not designed for the channel estimation method, here, the embodiment of the present invention only adopts a simple way of obtaining CorrC based on the strongest path determined in a single sampling manner by the SYNC-DL and the channel coefficient in the path.

S2(MFPhs) is the phase of the MFPhs^{th} subframe in the multiframe corresponding to the second multiframe state in Table 1.

Preferably, the determining module 86 comprises: a third calculation sub-module 862 which is configured to calculate [CorrM , S12Est]=max(abs(CorrR1),abs(CorrR2)) to obtain the decision result of the multiframe state, wherein CorrM is a larger value of an absolute value of CorrR1 and an absolute value of CorrR2, S12Est is the decision result of the multiframe state, CorrR1 is the first accumulated estimation value, CorrR2 is the second accumulated estimation value, abs is used for the modulo operation of CorrR1 and CorrR2, and max is used for calculating the larger value of abs(CorrR1) and abs(CorrR2).

In the preferred embodiment, it is determined that the decision result of the multiframe state is the first multiframe state or the second multiframe state by the accumulated estimation value with a larger modulus.

In addition, after the first accumulated estimation value and the second accumulated estimation value are obtained, it is also feasible to determine that the decision result of the multiframe state is the first multiframe state or the second multiframe state by selecting the one with a larger modulus square. The calculation method is max(CorrR1×conj(CorrR1) , CorrR2×conj(CorrR2)), wherein conj is used for calculating a conjugate complex.

It should be noted that the decision result of the multiframe state obtained by calculating the absolute value and that obtained by calculating the modulus square are equivalent in terms of result.

Preferably, the fine frequency offset estimation module 88 comprises a fourth calculation sub-module 882 which is configured to calculate FeqEst=angle(CorrR(S12Est))/pi×(1.28e6/496/2) to obtain a fine frequency offset value, wherein FeqEst is the fine frequency offset value, S12Est is the decision result of the multiframe state, angle is used for calculating the angle of CorrR(S12Est), and 1/1.28e6×496 is the duration between the central locations of the Midamble and SYNC-DL.

It should be noted that each subframe needs very little storage space and calculation, therefore the evaluation for the storage space and calculation is omitted here.

It should be noted that the fine frequency offset estimation apparatus described in the apparatus embodiments corresponds to the method embodiments, with the specific implementation described in the method embodiment in detail, thereby needing no further description.

To sum up, according to the embodiments of the present invention, the problems that the fine frequency offset estimation performed based on the hard decision of the data segment of the service time slot is low in data signal-to-noise ratio, influenced by hard decision errors and obviously coupled with other modules are solved by determining that the decision result of the multiframe state is the first multiframe state or the second multiframe state and performing the fine frequency offset estimation according to the decision result of the multiframe state. The present invention is less coupled with other modules, has excellent performance in various environments, and realizes the unbiased estimation of timing offset.

Obviously, those skilled in the art shall understand that the above-mentioned modules and steps of the present invention can be realized by using general purpose calculating device, can be integrated in one calculating device or distributed on a network which consists of a plurality of calculating devices. Alternatively, the modules and the steps of the present invention can be realized by using the executable program code of the calculating device. Consequently, they can be stored in the storing device and executed by the calculating device, or they are made into integrated circuit module respectively, or a plurality of modules or steps thereof are made into one integrated circuit module. In this way, the present invention is not restricted to any particular hardware and software combination.

The descriptions above are only the preferable embodiment of the present invention, which are not used to restrict the present invention. For those skilled in the art, the present invention may have various changes and variations. Any amendments, equivalent substitutions, improvements, etc. within the principle of the present invention are all included in the scope of the protection of the present invention.

## Claims

1. A fine frequency offset estimation method, **characterized by** comprising:
calculating a first accumulated estimation value corresponding to a first multiframe state according to a phase relevant value of a subframe and a phase of a subframe in the first multiframe state;
calculating a second accumulated estimation value corresponding to a second multiframe state according to the phase relevant value of the subframe and a phase of a subframe in the second multiframe state;
determining that a decision result of a multiframe state is the first multiframe state or the second multiframe state according to the first accumulated estimation value and the second accumulated estimation value; and
performing a fine frequency offset estimation according to the decision result of the multiframe state.

2. The method according to claim 1, **characterized in that** the step of calculating the first accumulated estimation value corresponding to the first multiframe state according to the phase relevant value of the subframe and the phase of the subframe in the first multiframe state comprises:
calculating CorrR1=CorrR1+CorrC×conj(S1(MFPhs)) to obtain the first accumulated estimation value, wherein CorrR1 is the first accumulated estimation value, CorrC is the phase relevant value of the subframe, S1(MFPhs) is the phase of the subframe in the first multiframe state, and conj is used for calculating a conjugate complex of S1(MFPhs).

3. The method according to claim 2, **characterized in that** before the step of calculating the first accumulated estimation value corresponding to the first multiframe state according to the phase relevant value of the subframe and the phase of the subframe in the first multiframe state, the method further comprises:
numbering the subframe in the first multiframe state by MFPhs according to a time order of the subframe in the first multiframe state; and
calculating CorrR1=zeros(2, 1) to obtain the first accumulated estimation value that is cleared, wherein CorrR1 is the first accumulated estimation value, and zeros is used for clearing CorrR1.

4. The method according to claim 1, **characterized in that** the step of calculating the second accumulated estimation value corresponding to the second multiframe state according to the phase relevant value of the subframe and the phase of the subframe in the second multiframe state comprises:
calculating CorrR2=CorrR2+CorrC×conj(S2(MFPhs)) to obtain the second accumulated estimation value, wherein CorrC is the phase relevant value of the subframe, and S2(MFPhs) is the phase of the subframe in the second multiframe state.

5. The method according to claim 4, **characterized in that** before the step of calculating the second accumulated estimation value corresponding to the second multiframe state according to the phase relevant value of the subframe and the phase of the subframe in the second multiframe state, the method further comprises:
numbering the subframe in the second multiframe state by MFPhs according to a time order of the subframe in the second multiframe state; and
calculating CorrR2=zeros(2, 1) to obtain the second accumulated estimation value that is cleared, wherein CorrR2 is the second accumulated estimation value, and zeros is used for clearing CorrR2.

6. The method according to claim 1, **characterized in that** the step of determining that the decision result of the multiframe state is the first multiframe state or the second multiframe state according to the first accumulated estimation value and the second accumulated estimation value comprises:
calculating [CorrM, S12Est]=max(abs(CorrR1), abs(CorrR2)) to obtain the decision result of the multiframe state, wherein CorrM is a larger value of an absolute value of CorrR1 and an absolute value of CorrR2, S12Est is the decision result of the multiframe state, CorrR1 is the first accumulated estimation value, CorrR2 is the second accumulated estimation value, abs is used for performing a modulo operation on CorrR1 and CorrR2, and max is used for calculating a larger value of abs(CorrR1) and abs(CorrR2).

7. The method according to claim 1, **characterized in that** the step of performing the fine frequency offset estimation according to the decision result of the multiframe state comprises:
calculating FeqEst=angle(CorrR(S12Est))/pi×(1.28e6/496/2) to obtain a fine frequency offset value, wherein FeqEst is the fine frequency offset value, S12Est is the decision result of the multiframe state, and angle is used for calculating an angle of CorrR(S12Est).

8. A fine frequency offset estimation apparatus, **characterized by** comprising:
a first calculation module which is configured to calculate a first accumulated estimation value corresponding to a first multiframe state according to a phase relevant value of a subframe and a phase of a subframe in the first multiframe state;
a second calculation module which is configured to calculate a second accumulated estimation value corresponding to a second multiframe state according to the phase relevant value of the subframe and a phase of a subframe in the second multiframe state;
a determining module which is configured to determine that a decision result of a multiframe state is the first multiframe state or the second multiframe state according to the first accumulated estimation value and the second accumulated estimation value; and
a fine frequency offset estimation module which is configured to perform fine frequency offset estimation according to the decision result of the multiframe state.

9. The apparatus according to claim 8, **characterized in that** the first calculation module comprises:
a first calculation sub-module which is configured to calculate CorrR1=CorrR1+CorrC×conj(S1(MFPhs)) to obtain the first accumulated estimation value, wherein CorrR1 is the first accumulated estimation value, CorrC is the phase relevant value of the subframe, S1(MFPhs) is the phase of the subframe in the first multiframe state, and conj is used for calculating a conjugate complex of S1(MFPhs).

10. The apparatus according to claim 8, **characterized in that** the second calculation module comprises:
a second calculation sub-module which is configured to calculate CorrR2=CorrR2+CorrC×conj(S2(MFPhs)) to obtain the second accumulated estimation value, wherein CorrR2 is the second accumulated estimation value, CorrC is the phase relevant value of the subframe, and S2(MFPhs) is the phase of the subframe in the second multiframe state.

11. The apparatus according to claim 8, **characterized in that** the determining module comprises:
a third calculation sub-module which is configured to calculate [CorrM , S12Est]=max(abs(CorrR1), abs(CorrR2)) to obtain the decision result of the multiframe state, wherein CorrM is a larger value of an absolute value of CorrR1 and an absolute value of CorrR2, S12Est is the decision result of the multiframe state, CorrR1 is the first accumulated estimation value, CorrR2 is the second accumulated estimation value, abs is used for performing a modulo operation on CorrR1 and CorrR2, and max is used for calculating a larger value of abs(CorrR1) and abs(CorrR2).

12. The apparatus according to claim 8, **characterized in that** the fine frequency offset estimation module comprises:
a fourth calculation sub-module which is configured to calculate FeqEst=angle(CorrR(S12Est))/pi×(1.28e6/496/2) to obtain a fine frequency offset value, wherein FeqEst is the fine frequency offset value, S12Est is the decision result of the multiframe state, angle is used for calculating an angle of CorrR(S12Est), and 1/1.28e6×496 is a duration between a central location of Midamble and a central location of downlink synchronous code.
